# EUROPEAN PATENT APPLICATION

(11) **EP 1 589 576 A2**
(43) Date of publication of application: **26.10.2005**
(21) Application number: 05250771.2
(22) Date of filing: 10.02.2005
(51) Int. Cl.: H01L 23/367, H01L 23/40

(54) **Heat dissipation in a drive circuit module for a plasma display device, for example**

(30) Priority: 20.04.2004 JP 2004124230; 20.04.2004 JP 2004124234
(71) Applicant: Fujitsu Hitachi Plasma Display Limited, Kawasaki-shi, Kanagawa 213-0012 (JP)
(72) Inventor: Ohno, Taizou Fujitsu Hitachi Plasma Display Ltd., Kawasaki-shi, Kanagawa 213-0012 (JP); Okada, Yoshinori Fujitsu Hitachi Plasma, Kawasaki-shi, Kanagawa 213-0012 (JP); Umehara, Kunio Fujitsu Hitachi Plasma Display Ltd., Kawasaki-shi, Kanagawa 213-0012 (JP); Kanazawa, Yoshikazu Fujitsu Hitachi Plasma, Kawasaki-shi, Kanagawa 213-0012 (JP); Kishi, Tomokatsu Fujitsu Hitachi Plasma, Kawasaki-shi, Kanagawa 213-0012 (JP); Koizumi, Haruo Fujitsu Hitachi Plasma Display Ltd., Kawasaki-shi, Kanagawa 213-0012 (JP); Kobayashi, Takayuki Fujitsu Hitachi Plasma, Kawasaki-shi, Kanagawa 213-0012 (JP); Sano, Yuji Fujitsu Hitachi Plasma Display Ltd., Kawasaki-shi, Kanagawa 213-0012 (JP)
(74) Representative: Wilding, Frances Ward

(57) **Abstract**

A drive circuit module (34) capable of dissipating heat produced by a semiconductor device, in the form of a bare chip, and in which the semiconductor device can be driven in a floating state, and a display device in which the drive circuit module is mounted have been disclosed. The drive circuit module comprises a heat dissipation plate (38), a flexible circuit board (36), an insulation layer having a wiring pattern (46), a semiconductor device mounting insulation layer (42), and a semiconductor device mounted on the heat dissipation plate via the semiconductor device mounting insulation layer, in which the insulation layer having the wiring pattern and the semiconductor device mounting insulation layer (42) are made of a non-conductive resin, the flexible circuit board (36) and the insulation layer having the wiring pattern are fixed on the heat dissipation plate (38) directly or indirectly, and the semiconductor device is electrically connected to the wiring pattern and the flexible circuit board.

## Description

The present invention relates to a display device, such as a plasma display device, and to a drive circuit module.

As described in EP 1006505, US 6,703,792, US 6,407,508, and US 6,703,702, a plasma display device comprises a pair of glass substrates each having a plurality of electrodes. A plasma display device has three kinds of electrodes. For example, the three kinds of electrode include a plurality of address electrodes parallel to each other and a plurality of X electrodes and a plurality of Y electrodes arranged by turns in parallel to the direction perpendicular to the address electrodes.

The address electrode is connected to an address pulse generation circuit via an address drive circuit module, the X electrode is connected to an X electrode sustain pulse generation circuit via a sustain drive circuit module, and the Y electrode is connected to a Y electrode sustain pulse generation circuit via a scan drive circuit module. The address drive circuit module and the scan drive circuit module each comprise a rigid drive circuit board, a flexible circuit board connected to the rigid drive circuit board, and a plurality of semiconductor devices mounted on the flexible circuit board. The input terminals of each semiconductor device are electrically connected to the wiring pattern of the rigid circuit board and the output terminals of each semiconductor device are electrically connected to the wiring pattern of the flexible circuit board.

As a semiconductor device produces a large amount of heat, there may be a need to dissipate heat produced by a semiconductor device. EP 1006505 has proposed a configuration in which a semiconductor device in the form of a bare chip, which is not contained in a package, is used, a heat dissipation plate is arranged adjacent to a plasma display panel in order to dissipate heat produced by the semiconductor device, the semiconductor device is attached to the heat dissipation plate, the input terminals of the semiconductor device are connected to a circuit board with a bonding wire, and the output terminals of the semiconductor device are connected to the electrodes of a glass substrate.

When the glass substrate has a small number of electrodes, it may be possible to directly connect the output terminals of the semiconductor device and the electrodes of the glass substrate, but when the glass substrate has a large number of electrodes, it is not possible to directly connect the output terminals of the semiconductor device and the electrodes of the glass substrate. Because of this, a flexible circuit board is used normally, and the terminals of the flexible circuit board are connected to the electrodes of the glass substrate.

In particular, as the semiconductor device in a scan drive circuit module produces a large amount of heat in scanning and sustaining actions, it is preferable that the heat produced by the semiconductor device be dissipated. However, as the semiconductor device in a scan drive circuit module is driven in a floating state, it is not possible to directly attach all of the semiconductor devices, in the form of bare chips, and which are not contained in packages, to a common heat dissipation plate (a metal plate).

It is desirable to provide a drive circuit module and a display device capable of dissipating heat produced by a semiconductor device in the form of a bare chip and driving the semiconductor device in a floating state.

A drive circuit module according to the present invention comprises: a heat dissipation plate, a flexible circuit board, an insulation layer having a wiring pattern, a semiconductor device mounting insulation layer, and a semiconductor device mounted on the heat dissipation plate via the semiconductor device mounting insulation layer, and in which the insulation layer having a wiring pattern and the semiconductor device mounting insulation layer are made of a flexible, non-conductive resin, the flexible circuit board and the insulation layer having the wiring pattern are directly or indirectly fixed on the heat dissipation plate, and the semiconductor device is electrically connected to the wiring pattern and the flexible circuit board.

In this configuration, the semiconductor device in the form of a bare chip is attached to the heat dissipation plate via the semiconductor device mounting insulation layer. The semiconductor device is arranged near the heat dissipation plate via a thin insulation layer, the heat produced by the semiconductor device is transferred to the heat dissipation plate with a relatively small heat resistance, and the heat is dissipated from the heat dissipation plate. Moreover, the semiconductor device is electrically separated from the heat dissipation plate by the insulation layer, the insulation between the semiconductor device and the heat dissipation plate is maintained, and the semiconductor device can be driven in a floating state.

Therefore, according to the present invention, it is possible to increase the capability to dissipate the heat produced by the semiconductor device while maintaining the insulation between the semiconductor device and the heat dissipation plate.

There can be various variations of the above-mentioned configuration. For example, the semiconductor device mounting insulation layer can be provided separately from the heat dissipation plate or together with the heat dissipation plate.

When it is necessary to mount the bottom surface of a semiconductor device in the form of a bare chip on a conductive layer on the insulation layer, the conductive layer is provided on the semiconductor device mounting insulation layer and, when not necessary, the conductive layer can be mounted directly on the insulation layer.

The semiconductor device mounting insulation layer can be provided separately from or together with the heat dissipation plate and it is also possible to use an insulation layer formed on the surface of a conductive heat dissipation plate by surface treatment. If a heat dissipation plate with the insulating properties such as a ceramic heat dissipation plate is used, it is not necessary to provide a semiconductor device mounting insulation layer and the semiconductor device can be attached directly to the heat dissipation plate. Moreover, when it is necessary to mount the semiconductor device on the conductive layer as described above, the semiconductor device is attached to the insulation layer or the conductive layer formed on the heat dissipation plate with the insulating properties.

It may be possible to use a rigid circuit board fixed on the heat dissipation plate instead of the flexible board having the wiring pattern. Moreover, if a connector is provided on the rigid circuit board and the connector is inserted into and fixed to a counterpart connector provided on a member fixed on a chassis, an integrated drive circuit module can be mechanically supported on the chassis of a display device using the connector and the counterpart connector.

If, in this configuration, a cutout is provided in an area where the heat dissipation plate overlaps a portion corresponding to a wiring pattern provided on at least one of the flexible circuit board and the rigid circuit board, a parasitic capacitance formed by the wiring pattern, the insulation layer, and the heat dissipation plate can be reduced. Therefore, noise contained in a signal can be reduced.

The semiconductor device and the flexible circuit board are electrically connected by means of at least one of an anisotropic conductive film (ACF) or soldering. It is possible to more easily connect the semiconductor device and the flexible circuit board electrically by means of an anisotropic conductive material or soldering.

In a display device according to the present invention, the flexible circuit board is connected to the drive electrodes using the above-mentioned drive circuit module.

The features and advantages of the invention will be more clearly understood from the following description taken in conjunction with the accompanying drawings, in which:
Fig.1 is a substantially perspective view showing a part of a plasma display device according to a first embodiment of the present invention;
Fig.2 is a diagram showing an arrangement of electrodes in the plasma display device in Fig.1;
Fig.3 is a substantially perspective view showing the plasma display device in Fig.1 including a circuit board;
Fig.4 is a sectional view showing a scan drive circuit module in the first embodiment in Fig.3;
Fig.5 is a top plan view showing the scan drive circuit module in Fig.4;
Fig.6 is a bottom plan view showing the scan drive circuit module in Fig.5;
Fig.7 is a substantially perspective view showing a part of the scan drive circuit module in Fig.4 to Fig.6;
Fig.8 is a sectional view along the line VIII-VIII in Fig.7;
Fig.9 is a sectional view along the line IX-IX in Fig.7;
Fig.10 is a diagram showing a circuit pattern of a first conductive layer at the top surface side of a common board:
Fig.11 is a diagram showing a circuit pattern of a second conductive layer at the bottom surface side of the common board;
Fig.12 is an enlarged view of a part including a semiconductor device in Fig.10;
Fig.13 is a sectional view showing a variation example of the scan drive circuit module in Fig.4;
Fig.14 is a diagram showing a circuit pattern corresponding to Fig.12 of the scan drive circuit module in Fig.13;
Fig.15 is a sectional view showing a scan drive circuit module according to a second embodiment of the present invention;
Fig.16 is a sectional view showing a variation example of the scan drive circuit module in Fig.15;
Fig.17 is a sectional view showing a variation example of the scan drive circuit module in Fig.15;
Fig.18 is a sectional view showing a scan drive circuit module according to a third embodiment of the present invention;
Fig.19 is a diagram showing the insertion of a connector into a counterpart connector;
Fig.20 is a diagram showing a variation example of the scan drive circuit module in Fig.18 and Fig.19;
Fig.21 is a diagram showing a variation example of the scan drive circuit module in Fig.18 and Fig.19;
Fig.22 is a diagram showing a variation example of the scan drive circuit module in Fig.15;
Fig.23 is a diagram showing a variation example of the scan drive circuit module in Fig.18;
Fig.24 is a sectional view showing a scan drive circuit module according to a fourth embodiment of the present invention;
Fig.25 is a top plan view showing the scan drive circuit module in Fig.24;
Fig.26 is a sectional view showing a scan drive circuit module according to a fifth embodiment of the present invention;
Fig.27 is a sectional view showing a scan drive circuit module according to a sixth embodiment of the present invention;
Fig.28 is a partly schematic diagram showing a variation example of the scan drive circuit module in Fig.26 and Fig.27;
Fig.29 is a sectional view showing a variation example of the scan drive circuit module in Fig.26 and Fig.27; and
Fig.30 is a sectional view showing a variation example of the scan drive circuit module in Fig.29.

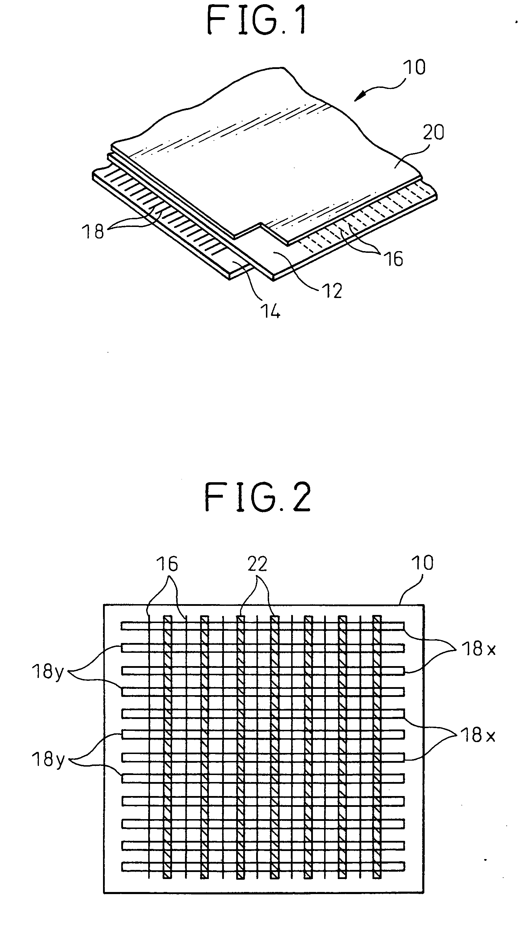

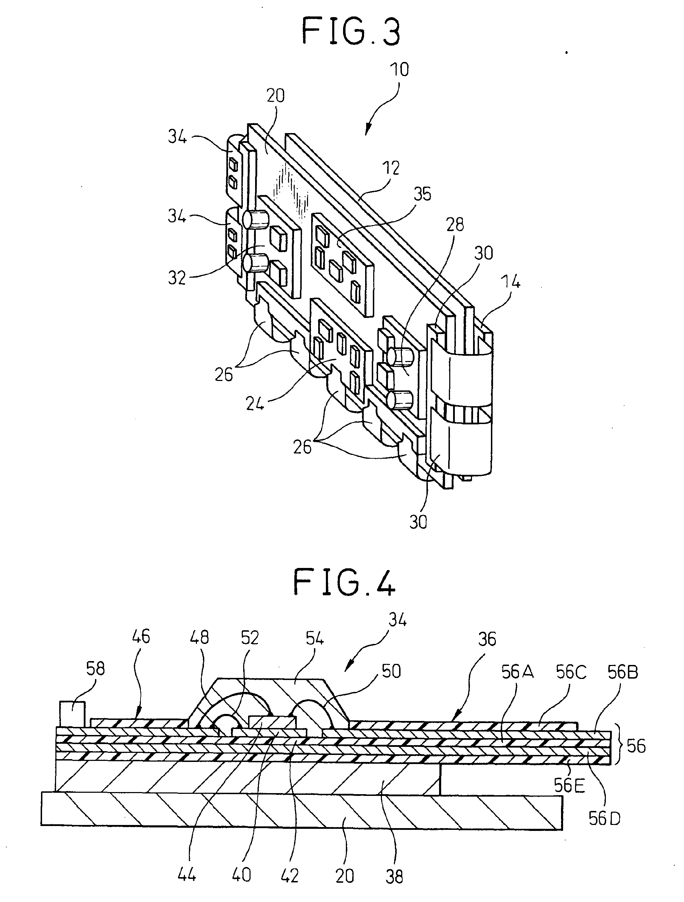

Embodiments of the present invention are described below with reference to the drawings. Fig.1 is a substantially perspective view showing a part of a plasma display device according to a first embodiment of the present invention. Fig.2 is a diagram showing an arrangement of electrodes in the plasma display device in Fig.1. Fig.3 is a substantially perspective view showing the plasma display device in Fig.1 including a circuit board. Although the present invention is described below while taking a plasma display device as an example, the present invention is not limited to a plasma display device but can be applied to other display devices having a plurality of drive electrodes such as an LCD, an EL Display, or an FED.

A plasma display device 10 comprises a pair of glass substrates 12 and 14 in opposition to each other, a chassis 20 fixed on the glass substrate 12, which is one of the glass substrates, and a drive circuit arranged on the chassis 20. The glass substrate 12 has a plurality of address electrodes 16 parallel to each another and the glass substrate 14 has a plurality of sustain discharge electrodes 18 extending in parallel to each another in the direction perpendicular to the address electrodes 16. In Fig.2, the sustain discharge electrodes 18 include X electrodes 18x and Y electrodes 18y arranged by turns. A partitioning wall 22 is formed between two adjacent ones of the address electrodes 16 in parallel to the address electrodes 16.

As shown in Fig.3, circuit boards having drive circuits for the address electrodes 16, the X electrodes 18x, and the Y electrodes 18y are arranged on the chassis 20. An address pulse generation circuit board 24 is connected to the address electrodes 16 via address drive circuit modules 26. An X electrode sustain pulse generation circuit board 28 is connected to the X electrodes 18x via sustain drive circuit modules 30. A Y electrode sustain pulse generation circuit board 32 is connected to the Y electrodes 18y via scan drive circuit modules 34. Moreover, a power supply circuit board 35 is arranged on the chassis 20. The respective drive circuit modules 26, 30, and 34 include respective flexible circuit boards for connecting the respective pulse generation circuit boards 24, 28, and 32 arranged on the chassis 20 and the respective electrodes 16, 18x, and 18y arranged in opposition to the chassis 20. The respective drive circuit modules 26, 30, and 34 include respective semiconductor devices for driving.

In the basic operations of the plasma display device 10, the glass substrate 14 is used as a display side. A display cell is formed between two adjacent ones of the partitioning walls 22 and between the X electrode 18x and the Y electrode 18y adjacent to each other. In a display cell, a pulse having a high writing voltage is applied between the address electrode 16 and the Y electrode 18y to generate priming by discharge and a pulse having a sustain discharge voltage is applied between the X electrode 18x and the Y electrode 18y to sustain a discharge and thereby the display cell is made to emit light.

Fig.4 is a sectional view showing the scan drive circuit module 34 in Fig.3. The scan drive circuit module 34 comprises a flexible circuit board 36 connected to the Y electrodes 18y, an insulation layer having a wiring pattern 46, a heat dissipation plate 38, an insulation layer 42 having a conductive layer 40, and a semiconductor device (a semiconductor chip) 44 mounted on the heat dissipation plate 38 via the insulation layer 42. The semiconductor device 44 is an IC chip in the form of a bare chip, and not contained in a package, and needs to be insulated from the heat dissipation plate 38, that is, needs to be in an electrically floating state with respect to the heat dissipation plate 20. By the way, the semiconductor device 44 is not limited to an IC chip, but a MOSFET can also be applied. The semiconductor device is fixed on the conductive layer 40 by means of a silver paste or soldering. The heat dissipation plate 38 is made of a metal plate having a high heat conductivity such as an aluminum plate. The input terminals of the semiconductor device 44 are electrically connected to the wiring pattern 46 and the output terminals of the semiconductor device 44 are electrically connected to the flexible circuit board 36.

The input terminal of the semiconductor device 44 is electrically connected to the wiring pattern 46 with a bonding wire 48 and the output terminal of the semiconductor device 44 is electrically connected to the wiring pattern of the flexible circuit board 36 with a bonding wire 50. Moreover, the conductive layer 40 is electrically connected to the ground of the wiring pattern 46 with a bonding wire 52. The semiconductor device 44 and the bonding wires 48, 50, and 52 are sealed with a sealing resin 54.

In Fig.4, the insulation layer 42 is made of a non-conductive resin. In particular, the insulation layer having the wiring pattern 46 and the insulation layer 42 having the conductive layer 40 have a structure similar to that of the flexible circuit board. In the embodiment shown in Fig.4, the insulation layer having the wiring pattern 46, the insulation layer 42 having the conductive layer 40, and the flexible circuit board 36 are formed on a flexible common board 56. In more detail, the common board 56 is manufactured from a double-sided copper-clad flexible board (CCL) and comprises a base film 56A, a first conductive layer 56B formed at one side of the base film 56A, a first cover film 56C covering the first conductive layer 56B, a second conductive layer 56D formed at the other side of the base film 56A, and a second cover film 56E covering the second conductive layer 56D. The base film 56A, the first cover film 56C, and the second cover film 56E are made of, for example a flexible, non-conductive resin such as polyimide. The thickness of the base film 56A is, for example, approximately 25 µm. The wiring pattern of the flexible circuit board 36 and the wiring pattern 46 are each formed as parts of the common board 56.

The second cover film 56E of the common board 56 is fixed on the heat dissipation plate 38 with an adhesive. The conductive layer 40 is configured by a part of the first conductive layer 56B of the common board 56 and the insulation layer 42 is configured by the base film 56A or the second cover film 56E. A part of the first cover film 56C is provided with an opening so that the semiconductor device 44 comes into contact with the conductive layer 40 (the first conductive layer 56B). The insulation layer on which the wiring pattern 46 is formed is configured by the base film 56A or the second cover film 56E.

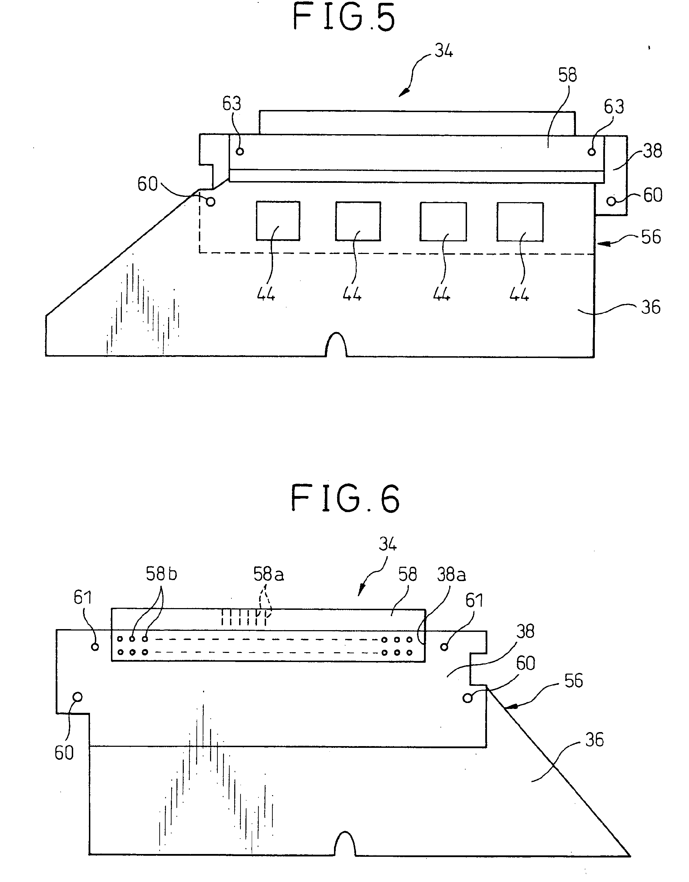

Moreover, a connector 58 is arranged at the end of the common board 56. The wiring pattern 46 is connected to the Y electrode sustain pulse generation circuit board 32 by the connector 58. The connector 58 comprises a terminal 58a connected to a counterpart connector connected to the Y electrode sustain pulse generation circuit board 32 and a terminal 58b connected to the drive circuit 46 (refer to Fig.6).

Fig.5 is a top plan view showing the scan drive circuit module in Fig.4 and Fig.6 is a bottom plan view showing the scan drive circuit module 34 in Fig.5. In Fig.5 and Fig.6, the flexible circuit board 36, the heat dissipation plate 38, the semiconductor devices 44, and the connector 58 are shown. The area of the heat dissipation plate 38 is smaller than the area of the common board 56 and the insulation layer 42 having the conductive layer 40 and the wiring pattern 46 are in the region where the heat dissipation plate 38 and the common board 56 overlap each other.

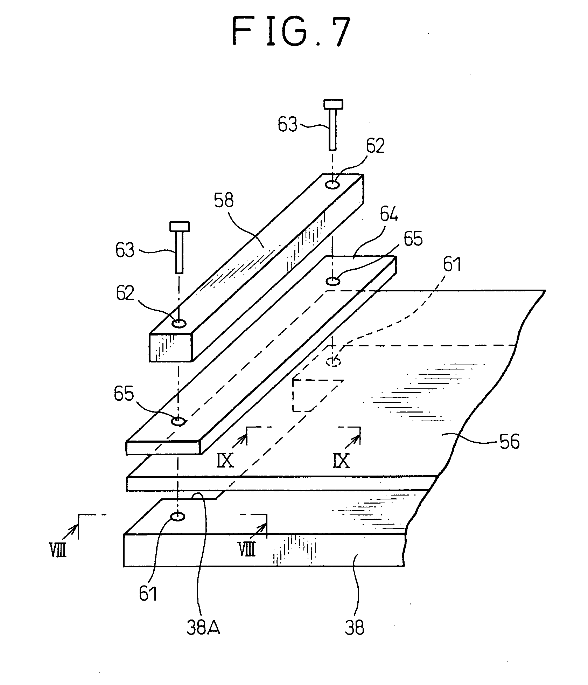

The heat dissipation plate 38 has holes 60 through which a screw for fixing the scan drive circuit module 34 to the chassis 20 is run and screw holes 61 into which a screw for fixing the connector 58 to the heat dissipation plate 38 is screwed. The connector 58 has holes 62 (refer to Fig.7) corresponding to the screw holes 61 of the heat dissipation plate 38 and screws 63 are screwed into the screw holes 61 through the holes 62. The heat dissipation plate 38 has a cutout 38A at the end thereof. In Fig.6, the terminal 58b of the connector 58 is exposed at the cutout 38A of the heat dissipation plate 38. In other words, a part (cutout) 38a of the heat dissipation plate 38 at which the terminal 58b of the connector 58 is located is cut out.

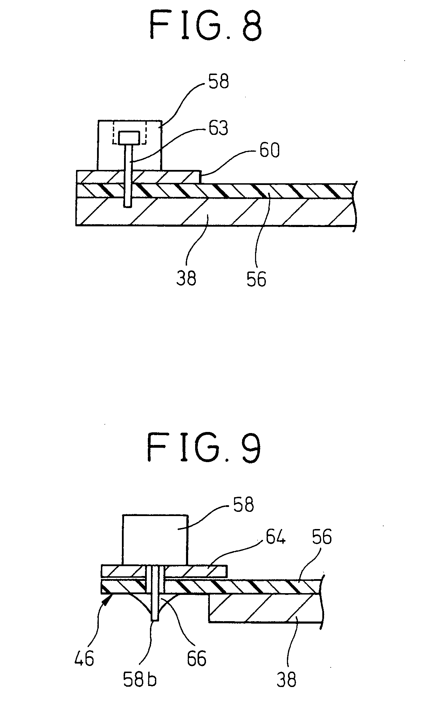

Fig.7 is a substantially perspective view showing a part of the scan drive circuit module 34 in Fig.4 to Fig.6. Fig.8 is a sectional view along the line VIII-VIII in Fig.7 and Fig.9 is a sectional view along the line IX-IX in Fig.7. The heat dissipation plate 38 having the cutout 38A is shown and further, a reinforcement plate 64 is shown. The reinforcement plate 64 has holes 65. The screws 63 are screwed into the screw holes 61 through the holes 62 and 65 and the connector 58 is fixed on the heat dissipation plate 38 via the reinforcement plate 64 and the common board 56.

As shown in Fig.9, the terminal 58b of the connector 58 is connected with solder 66 to the terminal of the wiring pattern 46 located at the end of the common board 56. If the end of the common board 56 is covered with the heat dissipation plate 38, soldering cannot be performed from under the common board 56. The cutout 38A is provided at the end of the heat dissipation plate 38 in order to enable soldering from under the common board 56.

In this case, the common board 56 is flexible and readily moved if not fixed at the cutout 38A of the heat dissipation plate 38. Because of this, the reinforcement plate 64 is used to press the common board 56 and prevent the movement of the common board 56 and, thus, soldering is enabled.

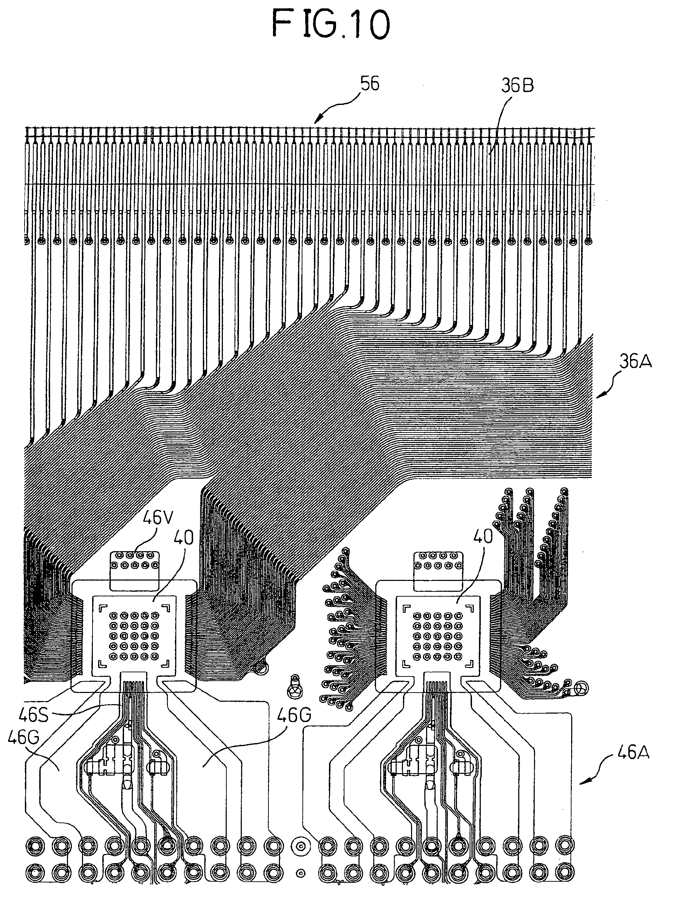

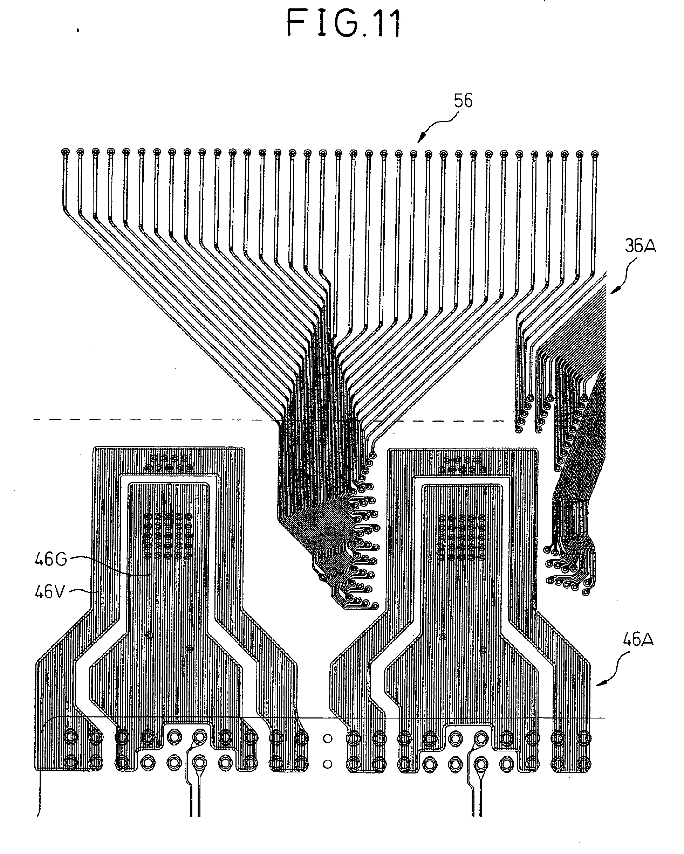

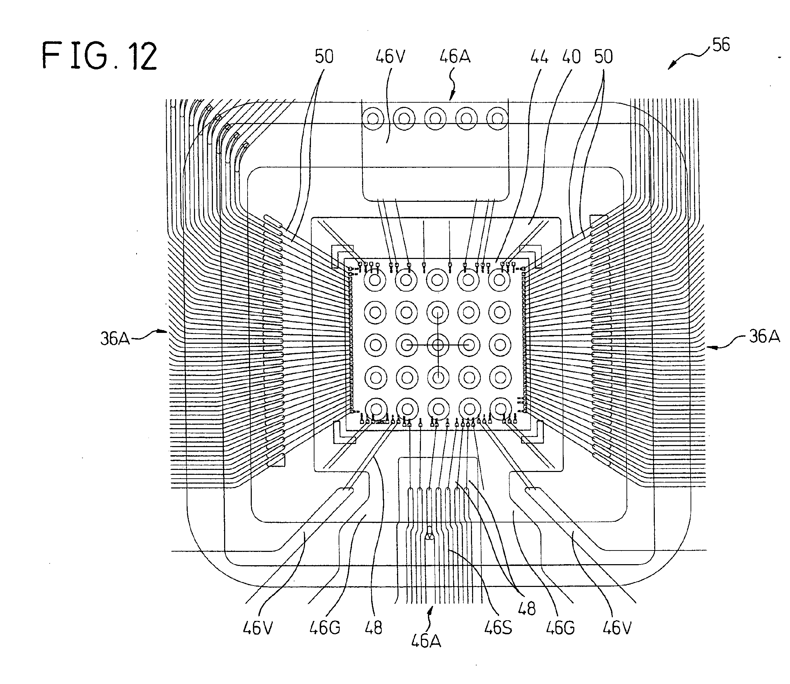

Fig.10 is a diagram showing the circuit pattern of the first conductive layer 56B at the top surface side of the common board 56. Fig.11 is a diagram showing the circuit pattern of the second conductive layer at the bottom surface side of the common board 56. Fig.12 is an enlarged view of a part of the circuit pattern including the semiconductor device 44 in Fig.10. Fig.10 shows the circuit pattern before the semiconductor device 44 is mounted and the conductive layer 40 is shown. The conductive layer 40 is formed in the form of an island. Fig.12 shows the circuit pattern after the semiconductor device 44 is mounted and the semiconductor device 44 is mounted on the conductive layer 40.

In Fig.10 to Fig.12, a circuit pattern 36A of the flexible circuit board 36 on the common board 56 is schematically shown and a part 46A of the wiring pattern 46 at the input side is schematically shown. The two layers of circuit pattern on and under the base film 56A are connected properly to each other by the through-holes provided in the base film 56A. Therefore, at the end of the circuit pattern 36A of the flexible circuit board 36, a group of terminals 36B to be connected to the Y electrodes 18y on the glass substrate 14 is formed in a row.

In Fig.10 and Fig.12, signal wires 46S, ground wires 46G, and power supply wires 46V of the wiring pattern 46 are shown, respectively. The signal wires 46S are arranged in a group near the center of a side of the rectangular semiconductor device 44. The two ground wires 46G are formed into a wide pattern at both sides of the group of the signal wires 46S and are continuous with the conductive layer 40. The two power supply wires 46V are formed into a wide pattern at the outside of the two ground wires 46G. Moreover, one of the power supply wires 46V is formed into a wide pattern near the opposite side of the semiconductor device 44.

In Fig.11, the ground wires 46G of the wiring pattern 46 are arranged in the area under the group of the signal wires 46S shown in Fig.10 and the power supply wires 46V are arranged so as to surround the ground wires 46G. Therefore, the wiring pattern 46 has the signal wires 46S on the first conductive layer 56B (Fig.10) and the ground wires 46G on the second conductive layer 56D (Fig.11). Moreover, the power supply wires 46V surround the signal wires 46S. As a result, even if the scan drive circuit module 34 contains the plural semiconductor devices 44 of different potentials, it is possible to reduce crosstalk on signal inputs via the heat dissipation plate 38 in each IC circuit composed of the semiconductor devices 44 and peripheral circuits. Particularly, crosstalk on the input signals, which causes malfunctions to occur, can be reduced considerably.

Moreover, in Fig.12, the bonding wires 48 connecting the input terminals of the semiconductor device 44 and the wiring pattern 46 and the bonding wires 50 connecting the output terminals of the semiconductor device 44 and the wiring pattern of the flexible circuit board 36 are shown. In Fig.10 and Fig.12, the ground wires 46G of the wiring pattern 46 are formed into a wide pattern and continuous with the conductive layer 40. In this case, the bonding wire 52 in Fig.4 can be omitted. Moreover, the power supply wires 46V are also formed into a wide pattern.

According to the configuration described above, the semiconductor device 44 is arranged near the heat dissipation plate 38 via the thin insulation layer 42, and heat produced by the semiconductor device 44 is transferred to the heat dissipation plate 38 with a relatively small heat resistance and is dissipated from the heat dissipation plate 38 having a high heat conductivity and a large heat capacity. Moreover, the semiconductor device 44 and the heat dissipation plate 38 are electrically separated from each other by the insulation layer 42, therefore, the insulation between the semiconductor device 44 and the heat dissipation plate 38 is maintained and the semiconductor device 44 can be driven in a floating state. The conductive layer 40 on the insulation layer 42 functions as a ground for each semiconductor device 44.

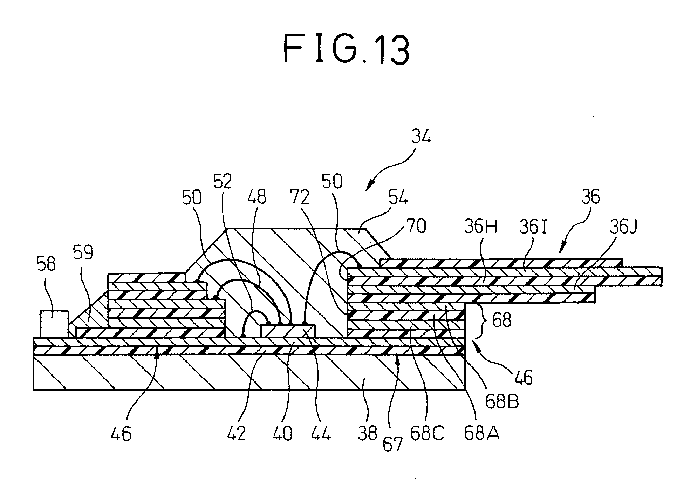

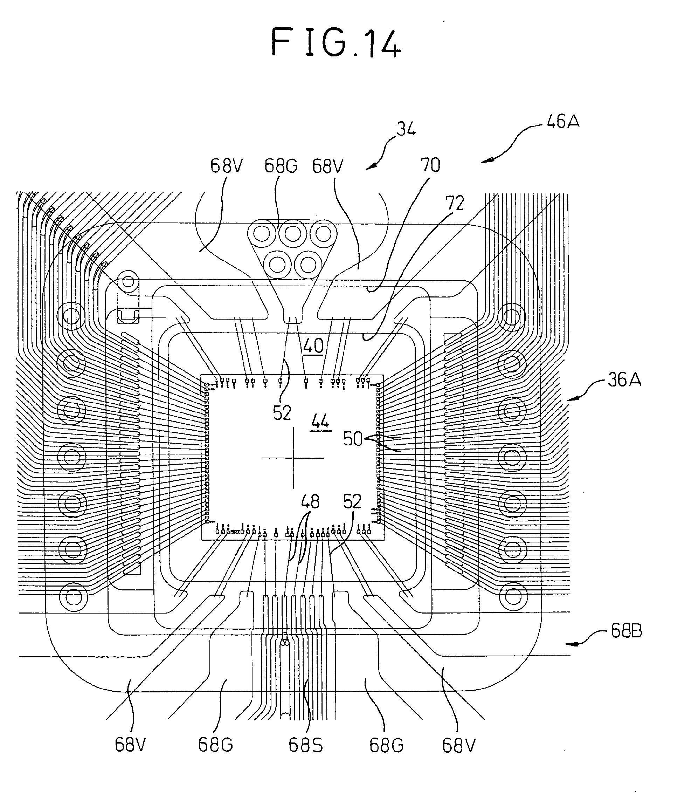

Fig.13 is a sectional view showing a variation example of the scan drive circuit module 34 in Fig.4. Fig.14 is a diagram showing a circuit pattern corresponding to the circuit pattern shown in Fig.12 of the scan drive circuit module 34 shown in Fig.13. The scan drive circuit module 34 comprises the flexible circuit board 36 connected to the Y electrodes 18y, the heat dissipation plate 38, the insulation layer 42 having the conductive layer 40, the insulation layer having the wiring pattern 46, and the semiconductor device (semiconductor chip) 44 mounted on the heat dissipation plate 38 via the insulation layer 42 and in contact with the conductive layer 40. The input terminals of the semiconductor device 44 are electrically connected to the wiring pattern 46 and the output terminals of the semiconductor device 44 are electrically connected to the flexible circuit board 36.

The input terminals of the semiconductor device 44 are electrically connected to a conductive layer 68B with the bonding wires 48 and the output terminals of the semiconductor device 44 are electrically connected to the circuit of the flexible circuit board 36 with the bonding wires 50. The wiring pattern 46 is connected to the semiconductor device 44 via the conductive layer 68B. Moreover, the conductive layer 40 is electrically connected to the ground of the semiconductor device 44 with the bonding wire 52. The semiconductor device 44 and the bonding wires 48, 50, and 52 are sealed with the sealing resin 54.

In Fig.13, the insulation layer 42 is made of a flexible, non-conductive resin. Particularly, the insulation layer having the wiring pattern 46 and the insulation layer 42 having the conductive layer 40 are made of a single-sided copper-clad flexible board (CCL). The CCL serves as a common board 67. The conductive layer 40 is a ground layer having a set-solid pattern. The conductive layer 40 under the semiconductor device 44 is configured into a set-solid pattern in the form of an island and, due to this wide conductive layer 40, the capability to dissipate heat from the semiconductor device 44 to the heat dissipation plate 38 can be increased and the ground potential of the semiconductor device 44 can be fixed in a floating state, thereby the operation of the semiconductor device 44 can be stabilized.

Moreover, a rigid circuit board 68 is provided on the common board 67. The rigid circuit board 68 comprises, for example, the first conductive layer 68B and a second conductive layer 68C on and under a glass-epoxy resin base layer 68A, respectively. On the first and second conductive layers 68B and 68C, circuit patterns are formed. The connector 58 is connected to the wiring pattern 46 of the common board 67 and the wiring pattern 46 is connected to the conductive layers 68B and 68C on the rigid circuit board 68 with solder 59.

The flexible circuit board 36 is arranged on the rigid circuit board 68. The flexible circuit board 36 is manufactured as a double-sided copper-clad flexible board (CCL) and has first and second conductive layers 36I and 36J on and under a base film 36H, respectively, and the first and second conductive layers 36I and 36J are covered with cover films, respectively. On the first and second conductive layers 36I and 36J, circuit patterns are formed.

The flexible circuit board 36 and the rigid circuit board 68 have openings 70 and 72 for exposing the conductive layer 40 so that the semiconductor device 44 is fixed on the conductive layer 40 on the insulation layer 42. The opening 70 of the flexible circuit board 36 and the opening 72 of the rigid circuit board 68 are shown clearly in Fig.14. The conductive layer 40 is exposed inside the opening 72 and the semiconductor device 44 is mounted on the conductive layer 40.

The conductive layer 68b of the rigid circuit board 68 shown in Fig.14 includes signal wires 68S, ground wires 68G, and power supply wires 68V. The signal wires 68S are arranged in a group near the center of a side of the rectangle of the semiconductor device 44 and the two ground wires 68G are formed into a wide pattern at both sides of the group of the signal wires 68S. The two power supply wires 68V are formed into a wide pattern at the outside of the two ground wires 68G. Moreover, one of the ground wires 68G and the two power supply wires 68V are formed into a wide pattern at the opposite side of the rectangle of the semiconductor device 44.

Under the group of the signal wires 68S in Fig.14, for example, the ground wires 68G and the power supply wires 68V, as shown in Fig.11, are provided. As a result, even if the scan drive circuit module 34 contains plural semiconductor devices 44 of different potentials, it is possible to reduce crosstalk via the heat dissipation plate 38 in each IC circuit group composed of each of the semiconductor devices 44 and peripheral circuits. Particularly, crosstalk on the input signals, which causes malfunctions to occur, can be reduced considerably.

According to the configuration described above, the semiconductor device 44 is arranged near the heat dissipation plate 38 via the thin insulation layer 42, and heat produced by the semiconductor device 44 is transferred to the heat dissipation plate 38 with a relatively small heat resistance and is dissipated from the heat dissipation plate 38 having a high heat conductivity and a large heat capacity. Moreover, the semiconductor device 44 and the heat dissipation plate 38 are electrically separated from each other by the insulation layer 42, therefore, the insulation between the semiconductor device 44 and the heat dissipation plate 38 is maintained and the semiconductor device 44 can be driven in a floating state. The conductive layer 40 on the insulation layer 42 functions as a ground of each semiconductor device 44. In this case, the rigid circuit board 68 does not often thermal resistance to the dissipation from the semiconductor device 44.

In the embodiment described above, the connection of the semiconductor device 44 and the wiring pattern 46 (or the conductive layer 68B) and the connection of the semiconductor device 44 and the flexible circuit board 36 are made with the bonding wires, but the connection can be made not only with the bonding wires. For example, the connection is made with a connecting means such as soldering or a flip-chip. The aluminum and copper of the terminals and electrodes of the conductive layer can be plated with gold or tin.

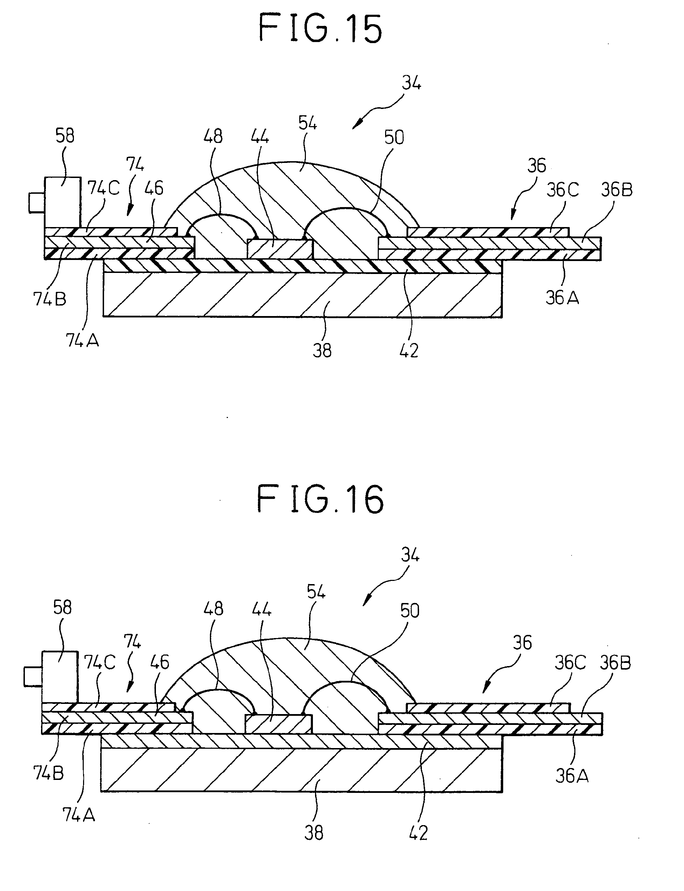

Fig.15 is a sectional view showing the scan drive circuit module 34 in a plasma display device according to a second embodiment of the present invention. The plasma display device in the second embodiment has a configuration similar to that in the first embodiment, but differs only in the configuration of the scan drive circuit module 34. In the first embodiment, the semiconductor device fixed on the conductive layer 40 is used, but in the second embodiment, a semiconductor device fixed on an insulation layer is used. The ground of a semiconductor device is connected to a circuit pattern with a bonding wire. In the scan drive circuit module in the first embodiment, the heat dissipation plate 38 and the insulation layer 42 are provided separately, but in the second embodiment, the heat dissipation plate 38 and the insulation layer 42 are formed integrally into one unit.

The scan drive circuit module 34 comprises the flexible circuit board 36 connected to the Y electrodes 18y, the wiring pattern 46, the heat dissipation plate 38, the insulation layer 42, and the semiconductor device (semiconductor chip) 44 mounted on the heat dissipation plate 38 via the insulation layer 42. The insulation layer 42 is integrally formed with the heat dissipation plate 38. The heat dissipation plate is made of a metal plate having a high heat conductivity such as an aluminum plate. The input terminals of the semiconductor device 44 are electrically connected to the wiring pattern 46 and the output terminals of the semiconductor device 44 are electrically connected to the flexible circuit board 36.

In Fig.11, the wiring pattern 46 is formed as a conductive layer of a rigid circuit board 74. The rigid circuit board 74 comprises a base film 74A, a conductive layer 74B formed at one side of the base film 74A, and a cover film 74C covering the conductive layer 74B, and the conductive layer 74B is patterned so as to form the wiring pattern 46. The base film 74A of the rigid circuit board 74 is made of, for example, a glass epoxy resin. The flexible circuit board 36 comprises the base film 36A, the conductive layer 36B formed at one side of the base film 36A, and the cover film 36C covering the conductive layer 36B, and the conductive layer 74B is patterned so as to have a wiring pattern. The base film 36A of the flexible circuit board 36 is made of, for example, polyimide.

The insulation layer 42 is made of a resin with the insulating properties. The insulation layer 42 is made of, for example, an epoxy resin or a silicone resin. It is preferable that the insulation layer 42 has a high heat conductivity and an insulating property. Therefore, the insulation layer 42 may be made of a resin mixed with an inorganic filler material with the insulating properties. For example, the insulation layer 42 may be made of an epoxy resin with a filler material.

The input terminals of the semiconductor device 44 are electrically connected to the wiring pattern 46 by with bonding wires 48 and the output terminals of the semiconductor device 44 are electrically connected to the wiring pattern of the flexible circuit board 36 with the boding wire 50. The semiconductor device 44 and the bonding wires 48 and 50 are sealed with the sealing resin 54.

The rigid circuit board 74 and the flexible circuit board 36 are mounted on the heat dissipation plate 38 having the insulation layer 42 and fixed on the heat dissipation plate 38 with an adhesive or screws. The semiconductor device 44 is mounted on the heat dissipation plate 38 having the insulation layer 42 independently of the rigid circuit board 74 and the flexible circuit board 36 and is fixed on the insulation layer 42 with an adhesive.

Moreover, the connector 58 is attached to the end of the circuit board 74. The wiring pattern 46 is connected to the Y electrode sustain pulse generation circuit board 32 by the connector 58. The connector 58 has a terminal connected to the terminal of a counterpart connector connected to the Y electrode sustain pulse generation circuit board 32 and a terminal connected to the wiring pattern 46.

According to the configuration described above, the semiconductor device 44 is arranged near the heat dissipation plate 38 via the thin insulation layer 42, and heat produced by the semiconductor device 44 is transferred to the heat dissipation plate 38 with a relatively small heat resistance and is dissipated from the heat dissipation plate 38 having a high heat conductivity and a large heat capacity. Moreover, the semiconductor device 44 and the heat dissipation plate 38 are electrically separated by the insulation layer 42, therefore, the insulation between the semiconductor device 44 and the heat dissipation plate 38 is maintained and the semiconductor device 44 can be driven in a floating state.

Fig.16 is a sectional view showing a variation example of the scan drive circuit module 34 according to the second embodiment shown in Fig.15. The scan drive circuit module 34 comprises the flexible circuit board 36 connected to the Y electrodes 18y, the wiring pattern 46, the heat dissipation plate 38, the insulation layer 42, and the semiconductor device (semiconductor chip) 44 mounted on the heat dissipation plate 38 via the insulation layer 42. The heat dissipation plate 38 is made of a metal plate having a high heat conductivity such as an aluminum plate. The input terminals of the semiconductor device 44 are electrically connected to the wiring pattern 46 and the output terminals of the semiconductor device 44 are electrically connected to the wiring pattern of the flexible circuit board 36.

The wiring pattern 46 is formed as a conductive layer of the rigid circuit board 74. The rigid circuit board 74 comprises the base film 74A, the conductive layer 74B formed at one side of the base film 74A, and the cover film 74C covering the conductive layer 74B, and the conductive layer 74B is patterned so as to form the wiring pattern 46. The base film 74A of the rigid circuit board 74 is made of, for example, a glass epoxy resin. The flexible circuit board 36 comprises the base film 36A, the conductive layer 36B formed at one side of the base film 36A, and the cover film 36C covering the conductive layer 36B, and the conductive layer 74B is patterned so as to have a wiring pattern. The base film 36A of the flexible circuit board 36 is made of, for example, polyimide.

In Fig.16, the insulation layer 42 is a portion of the surface of the heat dissipation plate 38, which has been treated so as to be non-conductive. In the case where the heat dissipation plate 38 is made of aluminum, the insulation layer 42 is a portion at which the aluminum has been alumite-processed. The alumite-processed portion has a high heat conductivity and has excellent insulating properties. The insulation layer 42 may be a portion of the heat dissipation plate 38 made of metal, to which a non-conductive process (for example, a process of turning the portion into an insulated portion by means of surface oxidization or chemical agents) is carried out.

Other characteristics of the scan drive circuit module 34 shown in Fig.16 are the same as those of the scan drive circuit module 34 shown in Fig.15 and the functions are also the same.

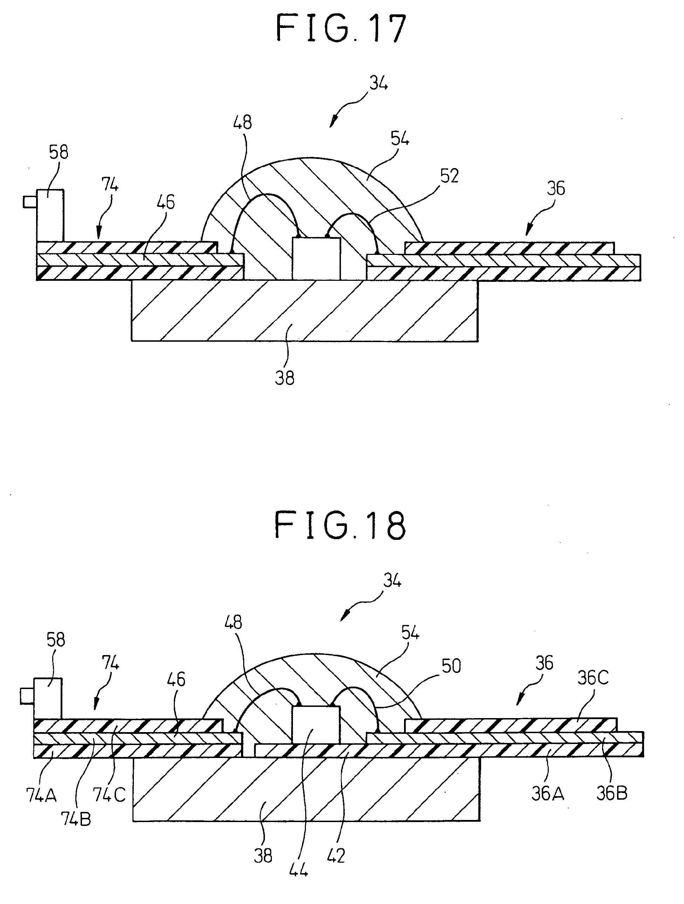

Fig.17 is a sectional view showing a variation example of the scan drive circuit module 34 according to the second embodiment shown in Fig.15. The scan drive circuit module 34 comprises the flexible circuit board 36 connected to the Y electrodes 18y, the wiring pattern 46, the heat dissipation plate 38 made of a material with the insulating properties, and the semiconductor device (semiconductor chip) 44 mounted on the heat dissipation plate 38. The input terminals of the semiconductor device 44 are electrically connected to the wiring pattern 46 and the output terminals of the semiconductor device 44 are electrically connected to the wiring pattern of the flexible circuit board 36.

In Fig.17, the insulation layer 42 shown in Fig.15 does not exist and the heat dissipation plate 38 is made of a material with the insulating properties. For example, the heat dissipation plate 38 is made of a ceramic having a high heat conductivity and the sufficient insulating properties. For example, alumina (Al₂O₃) or nitride aluminum (AlN) may be used as a material for the heat dissipation plate 38. Other characteristics of the scan drive circuit module shown in Fig.17 are the same as those of the scan drive circuit module 34 shown in Fig.15.

According to the configuration described above, as the semiconductor device 44 is mounted on the heat dissipation plate 38 made of a non-conductive material, heat produced by the semiconductor device 44 is transferred to the heat dissipation plate 38 with a relatively small heat resistance and dissipated from the heat dissipation plate 38 having a high heat conductivity and a large heat capacity. Moreover, the semiconductor device 44 and the heat dissipation plate 38 are electrically separated, the insulation between the semiconductor device 44 and the heat dissipation plate 38 is maintained and the semiconductor device 44 can be driven in a floating state.

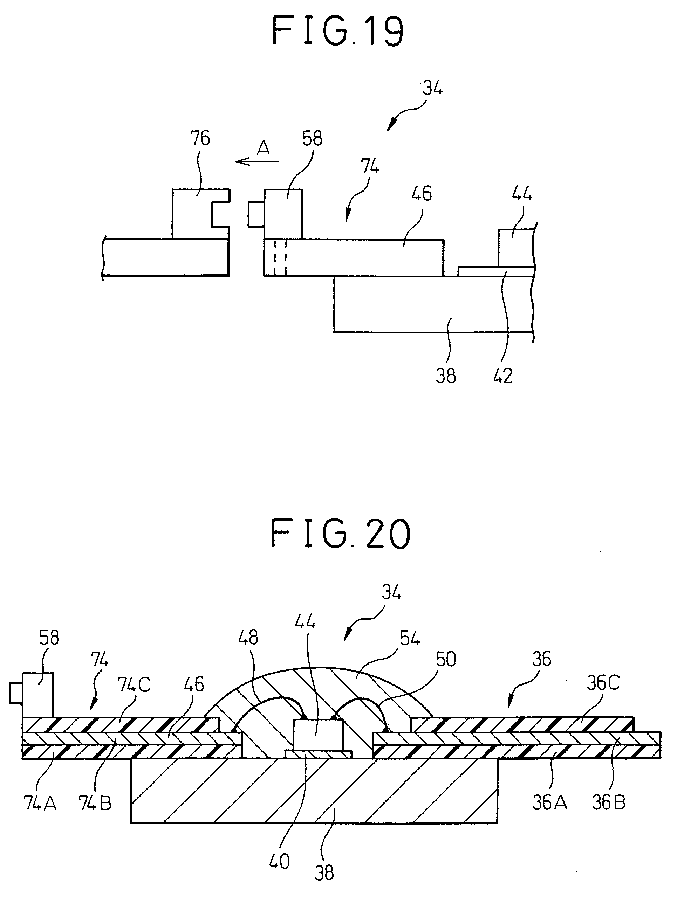

Fig.18 is a sectional view showing the scan drive circuit module 34 according to a third embodiment of the present invention. Fig.19 is a diagram showing the insertion of the connector shown in Fig.18 into the counterpart connector. The scan drive circuit module 34 comprises the flexible circuit board 36 connected to the Y electrodes 18y, the wiring pattern 46, the heat dissipation plate 38, the insulation layer 42, and the semiconductor device (semiconductor chip) 44 mounted on the heat dissipation plate 38 via the insulation layer 42. The heat dissipation plate 38 is made of a metal plate having a high heat conductivity such as an aluminum plate. The input terminals of the semiconductor device 44 are electrically connected to the wiring pattern 46 and the output terminals of the semiconductor device 44 are electrically connected to the wiring pattern of the flexible circuit board 36.

The wiring pattern 46 is formed as a conductive layer of the rigid circuit board 74. The configuration of the rigid circuit board 74 and the flexible circuit board 36 is the same as that shown in Fig.11. The insulation layer 42 is formed as a part of the base film 36A by extending the base film 36A of the flexible circuit board 36 as far as under the semiconductor device 44.

Moreover, the connector 58 is attached to the end of the rigid circuit board 74. The connector 58 is inserted into and fixed on a counterpart connector 76. In other words, the connector 58 can be inserted into and fixed on the counterpart connector 76 by moving the scan drive circuit module 34 in the direction of arrow A. The counterpart connector 76 is connected to the Y electrode sustain pulse generation circuit board 32 shown in Fig.3 and fixed on the chassis 20. As a result, the connector 58 is electrically connected to the Y electrode sustain pulse generation circuit board 32 via the counterpart connector 76 and is fixed on the chassis 20 mechanically. Therefore, the connector can support the scan drive circuit module 34 mechanically. The connector 58 has a terminal to be connected to the terminal of the counterpart connector 76 and a terminal (for example, a pin represented by a dotted line) connected to the wiring pattern 46.

In the embodiment shown in Fig.18 and Fig.19, even if the flexible circuit board 36 is not fixed on the rigid circuit board 74, the flexible circuit board 36 is fixed on the heat dissipation plate 38 together with the rigid circuit board 74'and these members are integrally formed with the scan drive circuit module 34, therefore, it is possible to support the heat dissipation plate 38 on the chassis 20 without a special support means for supporting the heat dissipation plate 38 by fixing the connector 58 to the rigid circuit board 74 and inserting the connector 58 into, and fixing it on, the counterpart connector 76.

Fig.20 is a diagram showing a variation example of the scan drive circuit module 34 shown in Fig.18 and Fig.19. The scan drive circuit module 34 shown in Fig.20 includes the heat dissipation plate 38 made of a material with insulating properties. Moreover, the conductive layer 40 is arranged between the heat dissipation plate 38 and the semiconductor device 44. The conductive layer 40 is connected to a floating ground. Others are the same as those of the scan drive circuit module 34 shown in Fig.18 and Fig.19. Therefore, the functions of the scan drive circuit module 34 shown in Fig.20 are the same as those of the scan drive circuit module 34 according to the third embodiment shown in Fig.18 and Fig.19.

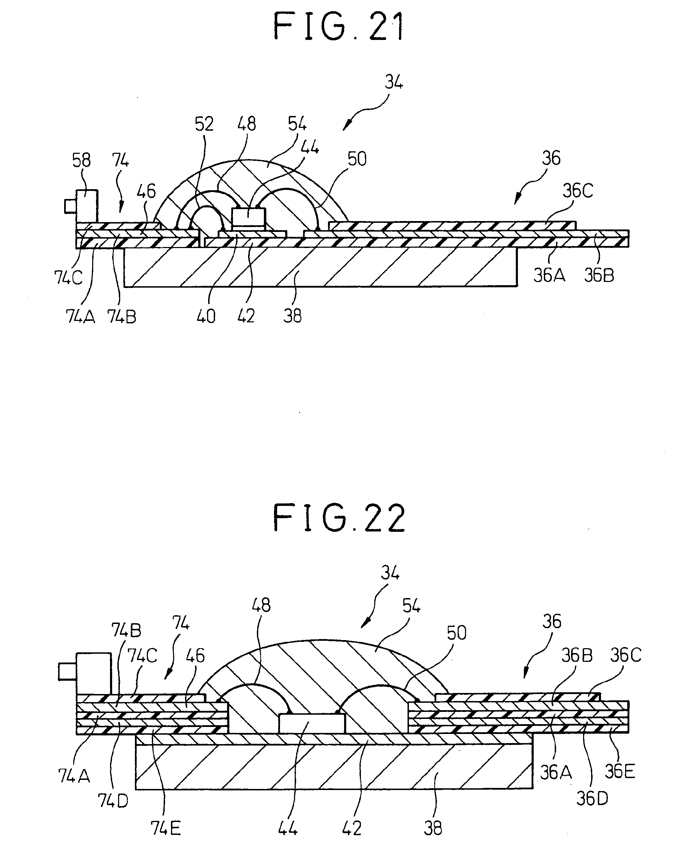

Fig.21 is a diagram showing a variation of the scan drive circuit module 34 according to the third embodiment shown in Fig.18 and Fig.19. The scan drive circuit module 34 shown in Fig.21 is the same as the scan drive circuit module 34 shown in Fig.18 and Fig.19 except in that the conductive layer 40 is mounted on the insulation layer 42 and the semiconductor device 44 is arrange on the conductive layer 40. The semiconductor device 44 is fixed on the conductive layer 40 by means of a silver paste or soldering. The conductive layer 40 is connected to the floating ground of the wiring pattern 46 with the bonding wires 52. Therefore, it is possible to reduce crosstalk via the heat dissipation plate 38 in each IC circuit group composed of the semiconductor device 44 and peripheral circuits. Particularly, crosstalk on the input signals, which causes malfunctions to occur, can be reduced considerably. Other functions of the scan drive circuit module 34 shown in Fig.21 are the same as those of the scan drive circuit module 34 shown in Fig.18 and Fig.19.

Fig.22 is a diagram showing a variation example of the scan drive circuit module 34 according to the second embodiment shown in Fig.15. The scan drive circuit module 34 shown in Fig.22 is the same as the scan drive circuit module 34 according to the second embodiment shown in Fig.15 except in that the rigid circuit board 74 and the flexible circuit board 36 are multilayer circuit boards. In other words, the flexible circuit board 36 comprises the base film 36A, the first conductive layer 36B formed at the upper side of the base film 36A, a first cover film 36C covering the first conductive layer 36B, a second conductive layer 36D formed at the lower part of the base film 36A, and a second cover film 36E covering the second conductive layer 36D. The base film 36A of the flexible circuit board 36 is made, for example, of polyimide. The rigid circuit board 74 comprises the base film 74A, the first conductive layer 74B formed at the upper side of the base film 74A, the first cover film 74C covering the first conductive layer 74B, a second conductive layer 74D formed at the lower side of the base film 74A, and a second cover film 74E covering the second conductive layer 74D. The base film 74A of the rigid circuit board 74 is made, for example, of a glass epoxy resin. On the multilayer circuit board, plural conductive layers are connected by through-holes.

The functions of the scan drive circuit module 34 shown in Fig.22 are the same as those of the scan drive circuit module 34 according to the second embodiment shown in Fig.15. In all the embodiments and all the variation examples except that shown in Fig.22, it is possible to form at least one of the rigid circuit board 74 and the flexible circuit board 36 from a multilayer circuit board.

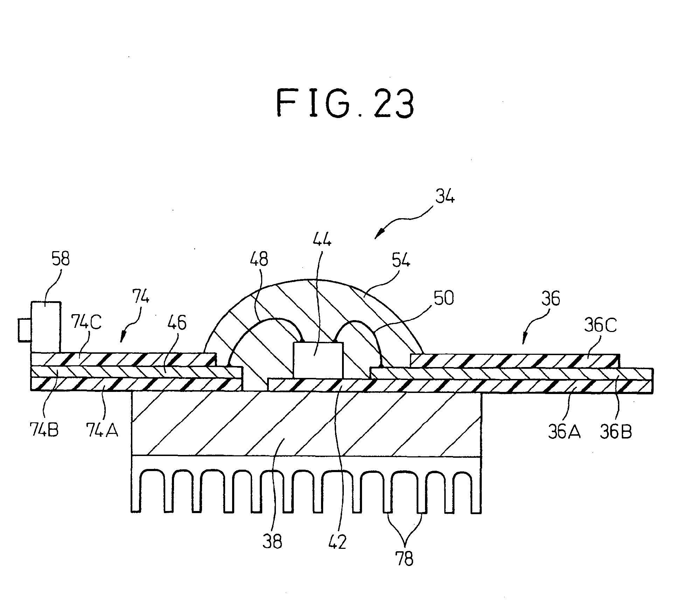

Fig.23 is a diagram showing a variation example of the scan drive circuit module 34 according to the second embodiment in Fig.15. The scan drive circuit module 34 in Fig.23 is the same as the scan drive circuit module 34 according to the second embodiment in Fig.15 except in that a heat dissipation fin 78 is attached to the heat dissipation plate 38. Due to the heat dissipation fin 78, the ability to dissipate heat of the heat dissipation plate 38 is further enhanced.

The functions of the scan drive circuit module 34 in Fig.23 are the same as those of the scan drive circuit module 34 according to the second embodiment shown in Fig.15. In all the embodiments and all the variations except that in Fig.23, it is possible to attach the heat dissipation fin 78 to the heat dissipation plate 38.

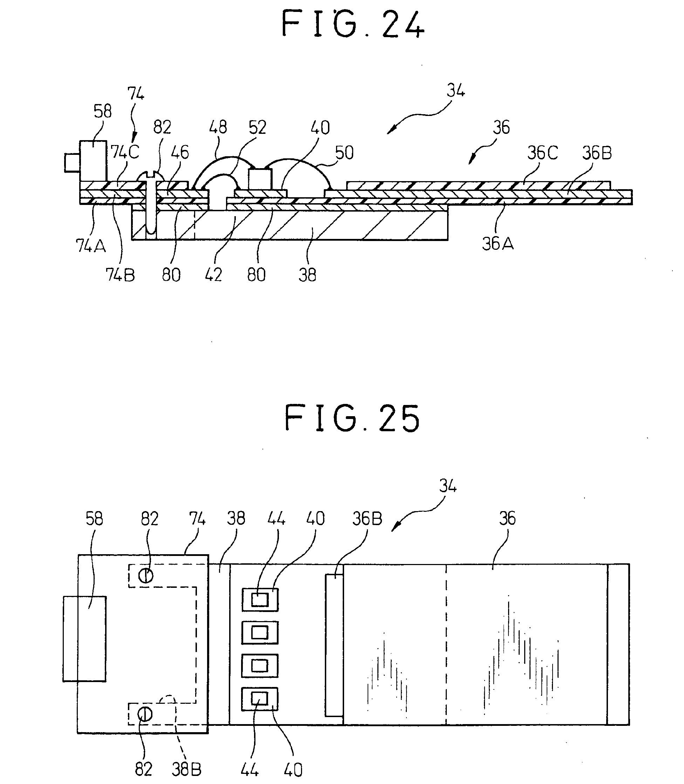

Fig.24 is a sectional view showing the scan drive circuit module 34 according to a fourth embodiment of the present invention. Fig.25 is a top plan view showing the scan drive circuit module 34 in Fig.24. In Fig.25, the bonding wires and the sealing resin are not shown. The scan drive circuit module 34 comprises the flexible circuit board 36 connected to the Y electrodes 18y, the wiring pattern 46, the heat dissipation plate 38, the insulation layer 42 having the conductive layer 40, and the semiconductor device (semiconductor chip) 44 mounted on the heat dissipation plate 38 via the insulation layer 42. The heat dissipation plate 38 is made from a metal plate having a high heat conductivity such as an aluminum plate. The input terminals of the semiconductor device 44 are electrically connected to the wiring pattern 46 and the output terminals of the semiconductor device 44 are electrically connected to the wiring pattern of the flexible circuit board 36.

The wiring pattern 46 is formed as a conductive layer of the rigid circuit board 74. The configuration of the rigid circuit board 74 and the flexible circuit board 36 is the same as that according to the second embodiment shown in Fig.15. The insulation layer 42 is formed as a part of the base film 36A by extending the base film 36A of the flexible circuit board 36 as far as under the semiconductor device 44. However, the insulation layer 42 may be a processed part of the resin or the heat dissipation plate 38 as described above. The conductive layer 40 can be formed as a part of the conductive layer 36 of the flexible circuit board 36. Reference numeral 80 denotes an adhesive for fixing the rigid circuit board 74 and the flexible circuit board 36 on the heat dissipation plate. Although an adhesive is not shown in other figures, an adhesive is used when necessary.

Moreover, the connector 58 is attached to the end of the rigid circuit board 74. The connector 58 is inserted into and fixed on the counterpart connector. The counterpart connector is connected to the Y electrode sustain pulse generation circuit board 32 in Fig.3 and is fixed on the chassis 20.

In Fig.24 and Fig.25, the heat dissipation plate 38 has a cutout 38B at a portion corresponding to the wiring pattern of the rigid circuit board 74. In other words, in Fig.25, the portion of the heat dissipation plate 38 located under the wiring pattern is formed into a channel shape. The ground of the wiring pattern 46 of the rigid circuit board 74 is in a floating state, but as the heat dissipation plate 38 is not electrically connected to the wiring pattern 46, the heat dissipation plate 38, the insulation layer (the base film 74A of the rigid circuit board 74), and the drive circuit 46 form a parasitic capacitance and if the parasitic capacitance becomes larger, noises will be mixed into the signal wires of the wiring pattern 46. As the part of the heat dissipation plate 38 located under the wiring pattern 46 is the cutout 38B, the parasitic capacitance is not formed and the noises mixed into the signal wires will be reduced. Moreover, although members such as chip capacitors or chip resistors are soldered to the rigid circuit board 74, the members are located in the area of the cutout 38B, it is unlikely that the members receive heat from the heat dissipation plate 38 and the reliability of the soldered parts can be prevented from being degraded.

The basic functions of the scan drive circuit module 34 according to the fourth embodiment in Fig.24 and Fig.25 are the same as the basic functions of the other embodiments. Moreover, the characteristics of the heat dissipation plate 38 in Fig.24 and Fig.25 can be applied to the other embodiments and variations.

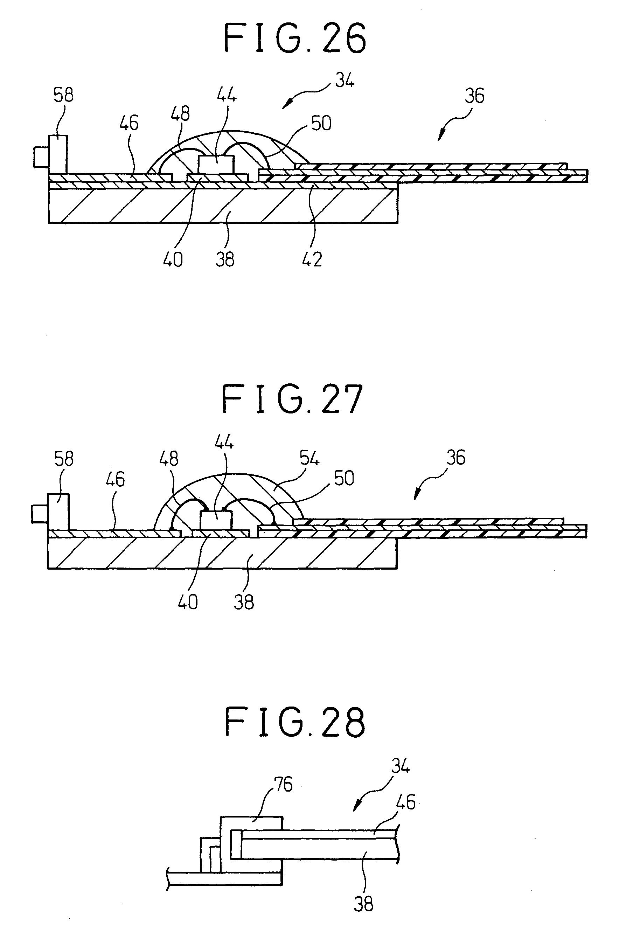

Fig.26 is a sectional view showing the scan drive circuit module 34 according to a fifth embodiment of the present invention. The scan drive circuit module 34 comprises the flexible circuit board 36 connected to the Y electrodes 18y, the wiring pattern 46, the heat dissipation plate 38 made of a conductive metal plate, the insulation layer 42 formed on the heat dissipation plate 38, and the semiconductor device (semiconductor chip) 44 mounted on the heat dissipation plate 38 via the insulation layer 42. The conductive layer 40 is formed on the insulation layer 42 and the semiconductor device 44 is arranged on the conductive layer 40. The input terminals of the semiconductor device 44 are electrically connected to the wiring pattern 46 and the output terminals of the semiconductor device 44 are electrically connected to the wiring pattern of the flexible circuit board 36.

In Fig.26, the wiring pattern 46 is a wiring pattern formed on the conductive layer provided directly on the surface of the insulation layer 42.

According to the configuration described above, the semiconductor device 44 is attached to the heat dissipation plate 38 via the thin insulation layer 42. Heat produced by the semiconductor device 44 is transferred to the heat dissipation plate 38 with a relatively small heat resistance and dissipated from the heat dissipation plate 38. The semiconductor device 44 and the heat dissipation plate 38 are electrically separated from each other, therefore, the insulation between the semiconductor device 44 and the heat dissipation plate 38 is maintained and the semiconductor device 44 can be driven in a floating state. Moreover, as the wiring pattern 46 is formed on the insulation layer 42 provided on the heat dissipation plate 38, it is not necessary to use another circuit board for the wiring pattern 46. The characteristics shown in Fig.26 can be applied to all the embodiments and all the variation examples having the insulation layer 42 described above.

Fig.27 is a sectional view showing the scan drive circuit module 34 according to a sixth embodiment of the present invention. The scan drive circuit module 34 comprises the flexible circuit board 36 connected to the Y electrodes 18y, the wiring pattern 46, the heat dissipation plate 38 made of a material with the insulating properties, and the semiconductor device (semiconductor chip) 44 mounted on the heat dissipation plate 38. The conductive layer 40 is formed on the heat dissipation plate 38 made of a material with the insulating properties and the semiconductor device 44 is arranged on the conductive layer 40. The input terminals of the semiconductor device 44 are electrically connected to the wiring pattern 46 and the output terminals of the semiconductor device 44 are electrically connected to the wiring pattern of the flexible circuit board 36.

In Fig.27, the wiring pattern 46 is a wiring pattern provided directly on the surface of the heat dissipation plate 38 made of a material with the insulating properties.

According to the configuration described above, the semiconductor device 44 is attached to the heat dissipation plate 38 having the insulating properties. Heat produced by the semiconductor device 44 is transferred to the heat dissipation plate 38 with a relatively small heat resistance and is dissipated from the heat dissipation plate 38. The semiconductor device 44 and the heat dissipation plate 38 are electrically separated, therefore, the insulation between the semiconductor device 44 and the heat dissipation plate 38 is maintained and the semiconductor device 44 can be driven in a floating state. Moreover, as the wiring pattern 46 is formed on the heat dissipation plate 38, it is not necessary to use another circuit board for the wiring pattern 46. The characteristics shown in Fig.27 can be applied to all the embodiments having the heat dissipation plate 38 with the insulating properties.

Fig.28 is a partly schematic diagram showing a variation example of the scan drive circuit module 34 in Fig.26 and Fig.27. In Fig.26 and Fig.27, the connector 58 is used but in Fig.28, the connector 58 is not used. In Fig.28, the wiring pattern 46 formed on the heat dissipation plate 38 with the insulating properties is inserted into the counterpart connector 76 together with the heat dissipating board 38.

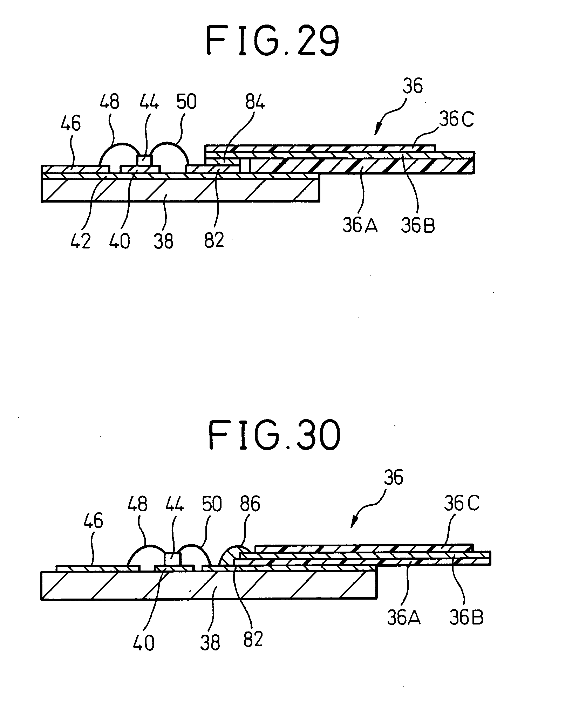

Fig.29 is a sectional view showing a variation example of the scan drive circuit module 34 in Fig.26 and Fig.27. In Fig.29, an intermediate conductive layer 82 is provided between the semiconductor device 44 and the flexible circuit board 36 and the bonding wire 50 connects the semiconductor device 44 and the intermediate conductive layer 82. Moreover, the intermediate conductive layer 82 is connected to the conductive layer 36B of the flexible circuit board 36 via an anisotropic conductive film 84. The wiring pattern 46, the conductive layer 40 under the semiconductor device 44, and the intermediate layer 82 are formed on the insulation layer 42 on the heat dissipation plate 38. Due to this, it becomes possible to electrically connect the flexible circuit board 36 and the semiconductor device 44 easily. By the way, instead of the heat dissipation plate 38 having the insulation layer 42 shown in Fig.29, the heat dissipation plate 38 having insulating properties can be used.

Fig.30 is a sectional view showing a variation example of the scan drive circuit module 34 shown in Fig.29. In Fig.30, the intermediate conductive layer 82 is connected to the conductive layer 36B of the flexible circuit board 36 using solder 86 instead of the anisotropic conductive film 84. Due to this, it becomes possible to electrically connect the flexible circuit board 36 and the semiconductor device 44 easily. Particularly, when connection is made on the flexible circuit board 36 by wire bonding, it is difficult to attach wires to the flexible circuit board 36, which is rather flexible, therefore, it is necessary to firmly fix the flexible circuit board 36 on the heat dissipation plate 38 by treatment such as thermal adhesion. As shown in Fig.29 and Fig.30, it is not so difficult to connect the semiconductor device 44 and the intermediate layer 82 firmed fixed on the heat dissipation plate 38 by wire bonding. Moreover it is relatively easy to connect the intermediate layer 82 and the flexible circuit board 36 using the anisotropic conductive film (ACF) 84 (refer to Fig.29) or the solder 86 (refer to Fig.30). Therefore, it is easy to make electrical connection if the semiconductor device 44 and the flexible circuit board 36 are electrically connected using at least one of the anisotropic conductive material and the solder.

In the embodiments described above, the connection between the semiconductor device 44 and the wiring pattern 46, and between the semiconductor device 44 and the flexible circuit board 36 is made using mainly bonding wires, but the connection is not limited to that using bonding wires. For example, the connection can be made using a connection means such as a soldering means or flip chips. Moreover, the aluminum or copper of the terminals of the conductive layer or the electrodes can be plated with gold or tin.

According to embodiments of the present invention, as described above, it is possible to obtain a display device with the improved ability to dissipate heat by arranging the semiconductor device near the heat dissipation plate while maintaining the insulation between the semiconductor device and the heat dissipation plate.

## Claims

1. A drive circuit module comprising:
a heat dissipation plate;
a flexible circuit board;
an insulation layer having a wiring pattern;
a semiconductor device mounting insulation layer; and
a semiconductor device mounted on the heat dissipation plate via the semiconductor device mounting insulation layer, wherein
the insulation layer having the wiring pattern and the semiconductor device mounting insulation layer are made of a flexible non-conductive resin,
the flexible circuit board and the insulation layer having the wiring pattern are fixed on the heat dissipation plate directly or indirectly, and
the semiconductor device is electrically connected to the wiring pattern and the flexible circuit board.

2. The drive circuit module as set forth in claim 1, wherein the semiconductor device mounting insulation layer has a conductive layer, and the semiconductor device is attached to the conductive layer.

3. The drive circuit module as set forth in claim 2, wherein the insulation layer having the wiring pattern, the semiconductor device mounting insulation layer, and the flexible circuit board are formed on a common board.

4. The drive circuit module as set forth in claim 2, wherein the insulation layer having the wiring pattern and the semiconductor device mounting insulation layer are formed on a common board, a rigid circuit board is arranged on the common board, and the flexible circuit board is arranged on the rigid drive circuit board.

5. The drive circuit module as set forth in claim 4, wherein the flexible circuit board and the rigid circuit board have an opening so that the semiconductor device is fixed on the conductive layer on the semiconductor device mounting insulation layer.

6. The drive circuit module as set forth in any one of claims 3 to 5, wherein the common board is composed of a base layer, at least one conductive layer is formed on the base layer, and a cover layer covers the conductive layer, and the base layer or the cover layer corresponds to the insulation layer.

7. The drive circuit module as set forth in claim 6, wherein the common board includes a second conductive layer formed on the opposite side on which the cover layer is formed on the base layer, and a second cover layer covering the second conductive layer.

8. The drive circuit module as set forth in claim 3 or 4, wherein a connector is connected to the wiring pattern and is attached to the common board.

9. The drive circuit module as set forth in claim 8, wherein the connector is fixed on the heat dissipation plate via the common board, and a portion of the heat dissipation plate at which the terminal of the connector is located is cut out.

10. The drive circuit module as set forth in claim 4 or 5, wherein the rigid circuit board includes a base layer, a first conductive layer formed at one side of the base layer, and a second conductive layer formed at the other side of the base layer.

11. The drive circuit module as set forth in claim 2, wherein the conductive layer on the semiconductor device mounting insulation layer is connected to the ground of the wiring pattern.

12. The drive circuit module as set forth in claim 2, wherein the conductive layer on the semiconductor device mounting insulation layer is a solid pattern connected to the ground of the wiring pattern.

13. The drive circuit module as set forth in claim 7 or 10, wherein the wiring pattern has signal wires on the first conductive layer and the ground wires on the second conductive layer.

14. The drive circuit module as set forth in claim 1, wherein the semiconductor device mounting insulation layer is made of a non-conductive resin.

15. The drive circuit module as set forth in claim 1, wherein the semiconductor device mounting insulation layer is a portion of the surface of the heat dissipation plate at which non-conductive treatment has been carried out.

16. The drive circuit module as set forth in claim 1, wherein the insulation layer having the wiring pattern is formed as an insulation layer of a rigid circuit board fixed on the semiconductor device mounting insulation layer.

17. The drive circuit module as set forth in claim 1, wherein the insulation layer having the wiring pattern corresponds to the semiconductor device mounting insulation layer and the wiring pattern is formed on the semiconductor device mounting insulation layer.

18. The drive circuit module as set forth in claim 1, further comprising a connector connected to the wiring pattern.

19. A drive circuit module comprising:
a heat dissipation plate made of a material with the insulating properties;
a flexible circuit board fixed on the heat dissipation plate;
a wiring pattern; and
a semiconductor device mounted on the heat dissipation plate, wherein
the semiconductor device is electrically connected to the wiring pattern and the flexible circuit board.

20. The drive circuit module as set forth in claim 19, wherein the wiring pattern is formed as a conductive layer of the rigid circuit board fixed on the heat dissipation plate.

21. The drive circuit module as set forth in claim 19, wherein the wiring pattern is formed on the heat dissipation plate.

22. The drive circuit module as set forth in claim 19, wherein the material with the insulating properties making up the heat dissipation plate is a ceramic.

23. The drive circuit module as set forth in claim 19, further comprising a connector connected to the wiring pattern.

24. A drive circuit module comprising:
a heat dissipation plate;
a flexible circuit board fixed on the heat dissipation plate;
a rigid circuit board fixed on the heat dissipation plate;
a semiconductor device mounted on the heat dissipation plate via an insulation layer being a part of the flexible circuit board; and
a connector attached to the rigid circuit board, wherein
the semiconductor device is electrically connected to the rigid circuit board and the flexible circuit board.

25. A drive circuit module comprising:
a heat dissipation plate;
a flexible circuit board fixed on the heat dissipation plate;
a rigid circuit board fixed on the heat dissipation plate; and
a semiconductor device mounted on the heat dissipation plate, wherein
the semiconductor device is electrically separated from the heat dissipation plate and is electrically connected to the rigid circuit board and the flexible circuit board, and
the heat dissipation plate has a cutout in the area in which the heat dissipation plate overlaps the wiring patter provided on at least one of the flexible circuit board and the rigid circuit board.

26. The drive circuit module as set forth in claim 25, wherein the heat dissipation plate has an insulation layer and the semiconductor device is mounted on the heat dissipation plate via the insulation layer.

27. The drive circuit module as set forth in claim 26, wherein the flexible circuit board is fixed on the insulation layer.

28. The drive circuit module as set forth in claim 26, wherein the insulation layer is a part of the flexible circuit board.

29. A drive circuit module comprising:
a heat dissipation plate;
a flexible circuit board fixed on the heat dissipation plate;
a wiring pattern; and
a semiconductor device mounted on the heat dissipation plate, wherein
the semiconductor device is electrically separated from the heat dissipation plate and is electrically connected to the wiring pattern and the flexible circuit board, and
the electrical connection between the semiconductor device and the flexible circuit board is made using at least one of an anisotropic conductive material and solder.

30. The drive circuit module as set forth in claim 29, wherein the heat dissipation plate has an insulation layer and the semiconductor device is mounted on the heat dissipation plate via the insulation layer.

31. The drive circuit module as set forth in claim 30, wherein the flexible circuit board is fixed on the insulation layer.

32. The drive circuit module as set forth in claim 30, wherein the insulation layer is a part of the flexible circuit board.

33. The drive circuit module as set forth in claim 30, wherein the heat dissipation plate further comprises a conductive layer provided between the insulation layer and the semiconductor device.

34. The drive circuit module as set forth in claim 29, wherein the heat dissipation plate is made of a material with insulating properties.

35. The drive circuit module as set forth in any one of claims 14, 15, 19, 24, 25, and 29, wherein a conductive layer is provided between the insulation layer of the heat dissipation plate and the semiconductor device and the semiconductor device is electrically connected to the conductive layer.

36. The drive circuit module as set forth in any one of claims 1 to 35, wherein the heat dissipation plate has a heat dissipation fin.

37. The drive circuit module as set forth in any one of claims 1 to 36, wherein the ground potential of the semiconductor device is connected to the ground of the wiring pattern.

38. The drive circuit module as set forth in claim 3, wherein the undersurface of the semiconductor device is connected to the wiring pattern using a conductive adhesive material.

39. The drive circuit module as set forth in claim 9, further comprising a reinforcement plate provided between the connector and the heat dissipation plate.

40. A display device comprising:
a pair of substrates;
a plurality of drive electrodes provided on the pair of substrates; and
a drive circuit module as set forth in any one of claims 1 to 39, wherein
the flexible circuit board is connected to the drive electrodes.

41. The display device as set forth in claim 40, wherein the display device comprises a plurality of address electrodes parallel to each other and a plurality of sustain discharge electrodes parallel to each other and provided in the direction perpendicular to the address electrodes, and the display device is composed of a plasma display device including the sustain discharge electrodes arranged by turns as X electrodes and Y electrodes, and the drive module drives the Y electrodes.
